# EUROPÄISCHE PATENTSCHRIFT

(11) **EP 2 454 783 B1**
(45) Veröffentlichungstag und Bekanntmachung des Hinweises auf die Patenterteilung: **25.09.2013**
(21) Anmeldenummer: 10737497.7
(22) Anmeldetag: 12.07.2010
(51) Int. Cl.: H01R 4/48, H01L 31/048, H02G 3/08

(54) **ANSCHLUSS- UND VERBINDUNGSVORRICHTUNG**
JOINING AND CONNECTING DEVICE
DISPOSITIF DE CONNEXION ET DE RACCORDEMENT

(30) Priorität: 15.07.2009 DE 102009033481
(43) Veröffentlichungstag der Anmeldung: 23.05.2012
(73) Patentinhaber: Phoenix Contact GmbH & Co. KG, 32825 Blomberg (DE)
(72) Erfinder: EUSTERHOLZ, Helmut, 33102 Paderborn (DE)
(74) Vertreter: Gesthuysen, Michael
(86) Internationale Anmeldenummer: PCT/EP2010/004226
(87) Internationale Veröffentlichungsnummer: WO 2011/006628

(56) Entgegenhaltungen:
- DE-A1-102005 025 632
- DE-A1-102007 006 433
- DE-U1-202008 006 116
- US-A1- 2005 161 080

## Beschreibung

Die Erfindung betriff eine Anschluss- und Verbindungsvorrichtung für den elektrischen Anschluss eines elektrischen Geräts, insbesondere eines Solarmoduls, mit einem ein Gehäuseunterteil und ein Gehäuseoberteil aufweisenden Gehäuse, mit mindestens einer Kontaktfeder zur elektrischen Kontaktierung mindestens einer vom elektrischen Gerät kommenden Anschlussleitung, mit mindestens einem in dem Gehäuse angeordneten Anschlusselement zum Anschluss mindestens eines Kabels, und mit mindestens einem Metallteil über das eine durch die Kontaktfeder kontaktierte Anschlussleitung mit einem durch das Anschlusselement angeschlossenen Kabel elektrisch leitend verbindbar ist, wobei das Gehäuse mindestens eine Öffnung zum Einführen des Kabels aufweist, wobei die Kontaktfeder, das Anschlusselement und das Metallteil dem Gehäuseunterteil zugeordnet sind und am Gehäuseoberteil mindestens ein Betätigungselement angeordnet ist, und wobei die Kontaktfeder beim Aufsetzen bzw. Aufdrücken des Gehäuseoberteils auf das Gehäuseunterteil aus einer ersten Position, in der die Kontaktfeder die Anschlussleitung nicht kontaktiert, in eine zweite Position verbringbar ist, in der die Anschlussleitung von der Kontaktfeder kontaktiert ist.

Zum Verbinden eines elektrischen Geräts mit einem Kabel bzw. zum Anschließen eines Kabels an ein elektrisches Gerät wird häufig eine Anschluss- und Verbindungsvorrichtung verwendet. Die Anschluss- und Verbindungsvorrichtung, die häufig auch als Anschlussdose oder Junction-Box bezeichnet wird, ist dabei mit ihrem Gehäuse an einer Seite des Geräts befestigt, wobei die Anschlussleitung bzw. die Anschlussleitungen des Geräts an dieser Seite durch die Gehäusewand des Geräts herausgeführt sind. Innerhalb der Anschlussdose ist eine Anschlussklemme angeordnet, an die einerseits die Anschlussleitungen des Geräts und andererseits die Adern der durch die Öffnungen in das Gehäuse eingeführten Kabel angeschlossen und dadurch elektrisch miteinander verbunden werden können.

Auch wenn derartige Anschluss- und Verbindungsvorrichtungen bei einer Vielzahl von elektrischen Geräten verwendet werden können, beispielsweise als Motoranschlussbox oder als Transformatoranschlussbox, so wird nachfolgend - ohne dass die Erfindung darauf beschränkt sein soll - als ein bevorzugtes Beispiel für ein elektrisches Gerät ein Solarmodul beschrieben, bei dem die Anschlussdose auf der der Sonnenseite abgewandten Rückseite des Solarmoduls angebracht ist.

In den letzten Jahren werden zunehmend photovoltaische Solarmodule zur Erzeugung von elektrischem Strom aus Sonnenlicht eingesetzt. Derartige Solarmodule, die häufig auch als Solarpaneele bezeichnet werden, bestehen aus einer Vielzahl von einzelnen Solarzellen, die nebeneinander liegend zwischen einer gemeinsamen vorderen Abdeckschicht und einer gemeinsamen rückseitigen Abdeckschicht angeordnet und miteinander verschaltet sind. Um höhere Spannungen zu erreichen, werden meist mehrere Solarmodule in Serie geschaltet. Hierzu ist bei jedem Solarmodul eine Anschlussdose auf der der Sonnenseite abgewandten Rückseite des Solarmoduls befestigt. Die von den Solarzellen des Solarmoduls kommenden Anschlussleitungen werden in der Anschlussdose mit entsprechenden Anschlusselementen elektrisch leitend verbunden, die mit Anschlusselementen für die externen Kabel verbunden sind. Die elektrische Verbindung der vom Solarmodul kommenden Anschlussleitungen, bei denen es sich in der Regel um Flachbänder handelt, an die Anschlusselemente der Anschlussdose erfolgt in der Regel manuell durch Löten oder Schrauben.

Der Aufwand bei der Montage der bekannten Anschlussdosen auf den Solarmodulen ist insbesondere durch das manuelle Verbinden (Löten oder Verschrauben) der Anschlussleitungen mit den in der Anschlussdose vorgesehenen Anschlusselementen relativ hoch. Aus der DE 10 2005 025 632 A1 ist eine Anschlussdose bekannt, bei der die Montage der Anschlussdose auf einem Solarmodul sowie die Herstellung der Anschlussdose vereinfacht sein soll. Bei der bekannten Anschlussdose, die ein topfförmiges Gehäuseunterteil und einen Gehäusedeckel aufweist, sind im Innenraum des Gehäuseunterteils mehrere Stanzgitter angeordnet, über die die ersten Anschlusselemente zum Anschluss der vom Solarmodul kommenden Anschlussleitungen mit den zweiten Anschlusselementen zum Anschluss der Kabel elektrisch verbunden sind. Während die ersten Anschlusselemente jeweils eine Klemmfeder aufweisen, sind die zweiten Anschlusselemente zum Anschluss der Kabel als Crimpanschlüsse ausgebildet.

Der Anschluss einer Anschlussleitung (Flachband) des Solarmoduls an einen Abschnitt des Stanzgitters erfolgt dabei dadurch, dass eine durch eine Öffnung in das Gehäuse eingeführte Anschlussleitung um einen am Stanzgitter ausgebildeten Anschlusssteg herumgeschlagen und anschließend durch Aufstecken der Klemmfeder festgeklemmt wird. Bei dieser Anschlussdose ist der elektrische Anschluss der Anschlussleitungen des Solarmoduls daher mit einem relativ hohen manuellen Aufwand verbunden.

Die DE 103 58 140 B4 offenbart eine Anschlussdose für ein Solarzellenmodul, die ebenfalls ein topfförmiges Gehäuseunterteil und einen Gehäusedeckel aufweist. Diese Anschlussdose weist eine Klemmfeder mit zwei gegeneinander wirkenden Federschenkeln auf, zwischen denen das anzuschließende Flachband eingeschoben wird. Um ein Abknicken des Flachbandes beim Einführen in die Anschlussdose zu vermeiden, ist unterhalb der Klemmfeder eine Führungseinrichtung mit einem Einführtrichter angeordnet, innerhalb der das Flachband mit geringem Spiel in Querrichtung geführt wird. Problematisch ist hierbei jedoch, dass die Klemmfeder beim Einführen des Flachbandes von diesem geöffnet werden muss, um in die Klemmstelle zwischen den beiden Federschenkeln zu gelangen.

Die DE 20 2008006 116 U1 offenbart eine Anschlußdose mit einer Überfeder.

Aus der DE 10 2007 006 433 A1 ist eine eingangs beschriebene Anschlussdose mit einem zweiteiligen Gehäuse bekannt, bei der sowohl das Anschlusselement für die Anschlussleitung als auch das Anschlusselement für das Kabel als Klemmfeder ausgebildet ist. Beide Klemmfedern weisen jeweils einen Klemmschenkel auf und sind über ein im Wesentlichen U-förmiges Metallteil miteinander verbunden. Die Klemmfedern zum Anschluss der Anschlussleitungen des Solarmoduls können dabei jeweils aus einer ersten Position, in der eine Anschlussleitung zwischen den Klemmschenkel und einen Kontaktabschnitt des Metallteils eingeführt werden kann, in eine zweite Position verschwenkt werden, in der die Anschlussleitung zwischen dem Klemmschenkel und dem Kontaktabschnitt des Metallteils klemmend kontaktiert ist. Die Herstellung der elektrischen Verbindung zwischen der Anschlussleitung und einem Kabel ist dadurch vereinfacht, dass an dem haubenförmigen Gehäuseoberteil ein nach innen ragendes Betätigungselement angeordnet ist, das beim vollständigen Aufsetzen des Gehäuseoberteils auf das Gehäuseunterteil die Klemmfeder aus der ersten Position in die zweite Position verschwenkt, so dass eine zwischen den Klemmschenkel der Klemmfeder und den Kontaktabschnitt des Metallteils eingeführte Anschlussleitung automatisch kontaktiert wird und somit ein manuelles Betätigen der Klemmfeder nicht erforderlich ist.

Die Montage der bekannten Anschlussdose auf dem Solarmodul erfolgt derart, dass zunächst die Kabel mit den entsprechenden Klemmfedern verbunden werden, dann das Gehäuseoberteil teilweise auf das Gehäuseunterteil aufgesetzt wird, anschließend das derart vormontierte Gehäuse so auf das Solarmodul aufgesetzt wird, dass die möglichst senkrecht nach oben stehende Anschlussleitungen des Solarmoduls durch zwei Öffnungen im Gehäuseunterteil jeweils zwischen den Klemmschenkel einer geöffneten Klemmfeder und den Kontaktabschnitt eines Metallteils eingeführt werden, und schließlich das Gehäuseoberteil in Richtung des Gehäuseunterteils gedrückt wird, wodurch die beiden Klemmfedern derart verschwenkt werden, dass die Anschlussleitungen automatisch kontaktiert werden.

Schwierigkeiten können sich bei der bekannten Anschlussdose dann ergeben, wenn die Anschlussleitungen nicht im wesentlichen senkrecht vom Solarmodul abstehen oder wenn die Anschlussdose nicht ausreichend genau positioniert wird, da es dann vorkommen kann, dass die Anschlussleitungen nicht durch die Öffnungen im Gehäuseunterteil zwischen den Klemmschenkel der geöffneten Klemmfedern und den Kontaktabschnitt der Metallteile gelangen.

Der vorliegenden Erfindung liegt daher die Aufgabe zugrunde, eine Anschluss- und Verbindungsvorrichtung für den elektrischen Anschluss eines elektrischen Geräts, insbesondere eines Solarmoduls, zur Verfügung zu stellen, die so ausgebildet ist, dass sie einfach und sicher montiert werden kann, wobei die Montage vorzugsweise automatisiert erfolgen soll. Außerdem soll die Anschlussdose weniger empfindlich gegenüber Toleranzen der Anschlussleitungen und deren Position sein.

Diese Aufgabe ist bei der eingangs beschriebenen Anschluss- und Verbindungsvorrichtung dadurch gelöst, dass die Kontaktfeder zwei Kontaktschenkel und einen die Kontaktschenkel verbindenden Rücken aufweist und dass eine Überfeder vorgesehen ist, die zwei Federschenkel und einen die Federschenkel verbindenden Rücken aufweist, wobei beim Aufsetzen bzw. Aufdrücken des Gehäuseoberteils auf das Gehäuseunterteil das nach innen ragende Betätigungselement am Gehäuseoberteil auf den Rücken der Überfeder drückt, so dass die Überfeder aus einer ersten Position in eine zweite Position verbracht wird. Die Überfeder ist dabei derart ausgebildet und relativ zur Kontaktfeder verschiebbar angeordnet, dass die Position mindestens eines Kontaktschenkels der Kontaktfeder durch die Überfeder so verändert wird, dass die Anschlussleitung zwischen den beiden Kontaktschenkel klemmend kontaktiert ist.

Die erfindungsgemäße Anschluss- und Verbindungsvorrichtung unterscheidet sich zunächst dadurch von der aus der DE 10 2007 006 433 A1 bekannten Anschlussdose, dass zusätzlich eine Überfeder vorgesehen ist, die beim Aufdrücken des Gehäuseoberteils auf das Gehäuseunterteil aus einer ersten, oberen Position in eine zweite, untere Position verbracht wird, wobei die Überfeder in der zweiten, unteren Position die Position mindestens eines Kontaktschenkels der Kontaktfeder so verändert, dass die Anschlussleitung zwischen den beiden Kontaktschenkel klemmend kontaktiert wird. Die Kontaktkraft auf die Anschlussleitung wird somit nicht von der Kontaktfeder sondern von der Überfeder aufgebracht. Da bei der erfindungsgemäßen Anschlussdose die Kontaktfeder bzw. der Kontaktbereich der Kontaktfeder beim Aufsetzen auf das Solarmodul geöffnet ist - und nicht wie bei der aus der DE 103 58 140 B4 bekannten Anschlussdose von der Anschlussleitung geöffnet werden muss - können auch dünne und gegen Abknicken empfindliche Anschlussleitungen sicher und zuverlässig kontaktiert werden.

Grundsätzlich kann die Kontaktfeder entweder zwei federnde Kontaktschenkel oder einen federnden und einen starren Kontaktschenkel aufweisen. Im ersten Fall werden die beiden Kontaktschenkel der Kontaktfeder von der Überfeder in deren zweiten, unteren Position zusammendrückt, d. h. beide Kontaktschenkel werden in ihrer Position verändert, indem sie beide in Richtung auf die Anschlussleitung ausgelenkt werden.

Die Anschluss- und Verbindungsvorrichtung unterscheidet sich dann auch dadurch von der aus der DE 10 2007 006 433 A1 bekannten Anschlussdose, dass die Anschlussleitung nicht zwischen einem Schenkel der Kontaktfeder und einem Schenkel des Metallteils sondern zwischen den beiden federnden Kontaktschenkeln der Kontaktfeder klemmend kontaktiert wird. Dadurch, dass die Anschlussleitung nicht zwischen einem Schenkel der Kontaktfeder und dem mit geringem Abstand davon angeordneten Kontaktabschnitt des Metallteils geklemmt wird, kann die Klemmstelle in der geöffneten Position sehr groß gewählt werden, so dass mit dieser erfindungsgemäßen Anschlussdose auch Anschlussleitungen sicher kontaktiert werden können, die relative große Positionstoleranzen aufweisen.

Weist die Kontaktfeder einen federnden und einen starren Kontaktschenkel auf, so wird nur der federnde Kontaktschenkel der Kontaktfeder von der Überfeder in deren zweiten, unteren Position ausgelenkt. Der federnde Kontaktschenkel wird dabei in Richtung des starren Kontaktschenkels bzw. der Anschlussleitung gedrückt, so dass die Anschlussleitung von dem Endbereich des federnden Kontaktschenkels gegen Endbereich des starren Kontaktschenkels gedrückt wird.

Bei dieser Ausgestaltung der Kontaktfeder ist der starre Kontaktschenkel vorzugsweise einstückig mit dem Metallteil und das Metallteil vorzugsweise ebenfalls einstückig mit dem Anschlusselement für das Kabel ausgebildet, wobei die Kontaktfeder und das Metallteil einfach als ein Stanz- und Biegeteil herstellbar sind. Darüber hinaus ist dann auch ein besonders guter Stromübergang zwischen der Anschlussleitung und dem Metallteil erreichbar.

Gemäß einer bevorzugten Ausgestaltung der Erfindung sind die Endbereiche der Kontaktschenkel der Kontaktfeder aufeinander zu gebogen, so dass die Endbereiche den Kontaktbereich der Kontaktfeder bilden. Dadurch wird ein im Wesentlichen linienförmiger Kontakt zwischen den Endbereichen der Kontaktschenkel und der Anschlussleitung realisiert, wodurch der Übergangswiderstand zwischen der Kontaktfeder und der Anschlussleitung verringert ist.

Gemäß einer vorteilhaften Ausgestaltung der Kontaktfeder sind die Kontaktschenkel, ausgehend vom Rücken der Kontaktfeder, zunächst aufeinander zu und dann zu ihren Endbereichen hin wieder voneinander weg gebogen. Dadurch weist die Kontaktfeder einen zwischen dem Rücken und den Endbereichen der Kontaktschenkel angeordneten Bereich auf, indem die Kontaktschenkel einen geringeren Abstand voneinander aufweisen. Durch eine derartige "zangenförmige" Ausgestaltung der Kontaktfeder kann die Anordnung der Überfeder an der Kontaktfeder besonders einfach und dennoch zuverlässig realisiert werden. Hierzu ist die Überfeder derart an der Kontaktfeder angeordnet, dass die Enden ihrer Federschenkel vor dem Aufsetzen bzw. Aufdrücken des Gehäuseoberteils auf das Gehäuseunterteil den Rücken der Kontaktfeder übergreifen.

Vorzugsweise sind dabei die Enden der Federschenkel der Überfeder aufeinander zu gebogen, wobei die Enden in der ersten Position der Überfeder in dem Bereich der Kontaktfeder enden, in dem deren Kontaktschenkel einen geringeren Abstand voneinander aufweisen. Dadurch ist die Überfeder in der ersten Position an der Kontaktfeder befestigt, wobei die Überfeder jedoch beim Aufdrücken des Gehäuseoberteils auf das Gehäuseunterteil nach unten, d. h. in Richtung der Enden der Kontaktschenkel der Kontaktfeder gedrückt werden kann. Bei diesem "Herunterdrücken" bzw. "Aufschieben" der Überfeder auf die Kontaktfeder werden die Endbereiche der Kontaktschenkel zusammengedrückt, so dass diese eine zwischen ihnen angeordnete Anschlussleitung klemmend kontaktieren.

Weist die Kontaktfeder einen federnden und einen starren Kontaktschenkel auf, so ist der federnde Kontaktschenkel vorzugsweise so ausgebildet, wie dies zuvor hinsichtlich beider Kontaktschenkel ausgeführt worden ist, d. h. der federnde Kontaktschenkel weist einen Endbereich auf, der in Richtung auf den starren Kontaktschenkel gebogen ist, wobei das Ende des federnden Kontaktschenkels zurück gebogen ist. Außerdem weist auch in diesem Fall die Kontaktfeder vorzugsweise einen Bereich auf, in dem die Kontaktschenkel einen geringeren Abstand voneinander aufweisen, wozu der federnde Kontaktschenkel ausgehend vom Rücken der Kontaktfeder zunächst auf den starren Kontaktschenkel zu und dann zu seinem Endbereich hin wieder vom starren Kontaktschenkel weg gebogen ist.

Eingangs ist ausgeführt, dass über das Metallteil eine durch die Kontaktfeder kontaktierte Anschlussleitung mit einem durch das Anschlusselement angeschlossenen Kabel elektrisch leitend verbindbar ist. Vorzugsweise sind dabei die Kontaktfeder und das Anschlusselement einstückig mit dem Metallteil verbunden, wodurch sich die Herstellung und Montage der erfindungsgemäßen Anschlussdose vereinfacht. Als Anschlusselement zum Anschließen des externen Kabels können grundsätzlich die aus dem Stand der Technik bekannten Anschlusselemente, beispielsweise Crimp-Anschluss, Schraubanschluss oder Zugfederanschluss verwendet werden.

Zur leichteren Anordnung und Befestigung des Metallteils an dem Gehäuseunterteil ist vorzugsweise mindestens ein Kontaktträger aus isolierendem Material mit dem Gehäuseunterteil verbunden, in dem das Metallteil bzw. die mit dem Metallteil verbundene Kontaktfeder und das Anschlusselement gehalten sind. Der Kontaktträger kann entweder als separates Bauteil in dem Gehäuseunterteil angeordnet oder einstückig mit dem Gehäuseunterteil verbunden sein.

Gemäß einer Ausgestaltung der Anschlussdose ist der das Metallteil sowie die Kontaktfeder und das Anschlusselement aufnehmende Kontaktträger derart beweglich mit dem Gehäuseunterteil verbunden, dass der Kontaktträger aus einer ersten Position in eine zweite Position verbracht werden kann. In der ersten Position ist der Kontaktträger dabei derart angeordnet, dass die Endbereiche der Kontaktschenkel der Kontaktfeder oberhalb einer anzuschließenden Anschlussleitung positioniert sind, wenn das Gehäuseunterteil auf das elektrische Gerät aufgesetzt ist. In der zweiten, unteren Position des Kontaktträgers ist dagegen die Anschlussleitung zwischen den Endbereichen der Kontaktschenkel der Kontaktfeder angeordnet, so dass die Anschlussleitung dann, wenn die Kontaktschenkel durch die Überfeder zusammengedrückt werden, kontaktiert wird.

Vorzugsweise ist bei dieser Ausführungsform der Kontaktträger sowohl in seiner ersten Position als auch in seiner zweiten Position fixierbar, wozu zwischen dem Gehäuseunterteil und dem Kontaktträger zwei Verrastungen ausgebildet sind. Hierzu können beispielsweise an einer Innenseite des Gehäuseunterteils zwei Rastausnehmungen und an der gegenüberliegenden Seite des Kontaktträgers eine korrespondierende Rastnase ausgebildet sein. Beim Aufdrücken des Gehäuseoberteils auf das Gehäuseunterteil wird dabei der Kontaktträger dadurch aus seiner ersten Position in seine zweite Position verbracht, dass beim Herunterdrücken des Gehäuseoberteils das Betätigungselement auf den Rücken der Überfeder drückt, wobei die Kraft über die Überfeder auf die Kontaktfeder übertragen wird, so dass die Kontaktfeder zunächst ebenfalls nach unten gedrückt wird. Da die Kontaktfeder mit dem Metallteil verbunden ist und das Metallteil in dem Kontaktträger angeordnet ist, wird somit auch der Kontaktträger nach unten, in seine zweite Position gedrückt. Erst danach wird die Überfeder relativ zur Kontaktfeder verschoben, d. h. die Überfeder wird auf die Kontaktfeder aufgeschoben, wodurch die Kontaktschenkel zusammengedrückt werden.

Gemäß einer anderen Ausführungsform ist das Metallteil nicht einstückig mit der Kontaktfeder und dem Anschlusselement verbunden, sondern über ein weiteres Bauelement, insbesondere eine Leiterplatte oder eine Metallplatte, beispielsweise ein Leadframe, mit dem Anschlusselement verbunden. Vorzugsweise sind auch hierbei die Kontaktfeder und das Metallteil einstückig miteinander verbunden. Bei dieser Ausführungsvariante kann das Kabel an dem weiteren Bauteil angelötet sein, so dass das Anschlusselement als auf dem Bauteil angeordneter Lötanschluss ausgebildet ist.

Die Verbindung des Metallteils mit dem weiteren Bauelement, insbesondere einer Leiterplatte, erfolgt vorzugsweise dadurch, dass das Metallteil an seinem freien, nicht mit der Kontaktfeder verbundenen Ende mindestens einen Lötanschlusspin aufweist, wobei dann in dem Bauelement eine korrespondierende Bohrung zum Einstecken oder Einpressen des Lötanschlusspins ausgebildet ist. Die elektrische Verbindung wird hier dadurch weiter erhöht, dass der Lötanschlusspin in der Bohrung verlötet ist. Da bei dieser Ausführungsform das Metallteil vorzugsweise einstückig mit der Kontaktfeder verbunden ist, kann auf die Verwendung des zuvor beschriebenen Kontaktträgers verzichtet werden.

Gemäß einer weiteren bevorzugten Ausgestaltung der Erfindung, die unabhängig davon realisiert sein kann, ob überhaupt ein Kontaktträger vorhanden ist und ob der Kontaktträger starr oder beweglich mit dem Gehäuseunterteil verbunden ist, sind auch zwischen dem Gehäuseunterteil und dem Gehäuseoberteil zwei Verrastungen ausgebildet, so dass das Gehäuseunterteil und das Gehäuseoberteil sowohl in der ersten Position als auch in der zweiten Position zueinander fixierbar sind. Dadurch ist sichergestellt, dass das Gehäuseoberteil weder ungewollt auf das Gehäuseunterteil aufgedrückt wird, wodurch die Kontaktstelle zwischen den beiden Kontaktschenkeln der Kontaktfeder geschlossen würde, noch dass das Gehäuseoberteil ungewollt von dem Gehäuseunterteil abgehoben werden und eventuell verloren gehen kann.

Eingangs ist ausgeführt worden, dass die Anschluss- und Verbindungsvorrichtung mindestens eine Kontaktfeder zur Kontaktierung mindestens einer Anschlussleitung, mindestens ein Anschlusselement zum Anschluss mindestens eines Kabels und mindestens ein Metallteil aufweist. In der Regel werden durch die Anschlussdose mindestens zwei als Kupferflachbänder ausgebildete Anschlussleitungen mit zwei von der Anschlussdose wegführenden Kabeln elektrisch verbunden, so dass die Anschlussdose in der Regel auch zwei Kontaktfedern, zwei Anschlusselemente, zwei Metallteile sowie zwei Überfedern aufweist. In diesem "Normalfall" sind an dem Gehäuseoberteil dann auch zwei nach innen ragende Betätigungselemente angeordnet, die jeweils eine Überfeder beim Aufrasten des Gehäuseoberteils auf das Gehäuseunterteil auf eine Kontaktfeder aufschieben.

Die Montage der erfindungsgemäßen Anschluss- und Verbindungsdose auf einer Seite eines elektrischen Geräts, insbesondere auf einem Solarmodul, kann dadurch weiter vereinfacht und dabei auch automatisiert werden, dass auf der dem Gehäuseoberteil abgewandten Seite des Gehäuseunterteils, d. h. auf der Seite, mit der das Gehäuseunterteil auf das Solarmodul aufgesetzt wird, eine Klebstoffschicht aufgebracht ist. Dadurch kann das Gehäuse automatisch auf der Rückseite eines Solarmoduls positioniert und gleichzeitig durch die Klebstoffschicht befestigt werden. Die Klebstoffschicht kann dabei gleichzeitig auch die Funktion einer Abdichtung übernehmen.

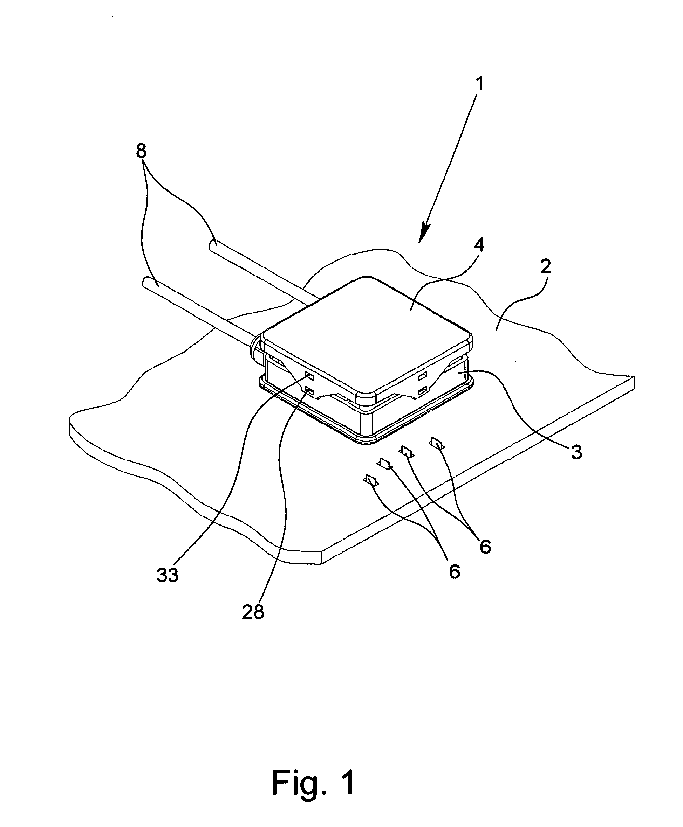

Im Einzelnen gibt es nun eine Vielzahl von Möglichkeiten, die erfindungsgemäße Anschluss- und Verbindungsdose auszugestalten und weiterzubilden. Dazu wird verwiesen sowohl auf die Patentansprüche, als auch auf die nachfolgende Beschreibung bevorzugter Ausführungsbeispiele in Verbindung mit der Zeichnung. In der Zeichnung zeigen
- Fig. 1: eine perspektivische Darstellung einer Anschluss- und Verbindungsvorrichtung und eines Solarmoduls,
- Fig. 2: die Anschluss- und Verbindungsvorrichtung gemäß Fig. 1, aufgesetzt auf das Solarmodul, in einer die Anschlussleitung noch nicht kontaktierenden Position, mit teilweise weggeschnittenem Gehäuse,
- Fig. 3: die Anschluss- und Verbindungsvorrichtung in der die Anschlussleitung kontaktierenden Position, mit teilweise weggeschnittenem Gehäuse,
- Fig. 4: eine Frontansicht eines Ausschnitts der Anschluss- und Verbindungsvorrichtung, in der Position gemäß Fig. 2,
- Fig. 5: eine Frontansicht eines Ausschnitts der Anschluss- und Verbindungsvorrichtung, in der zweiten Position gemäß Fig. 3,
- Fig. 6: die Anschluss- und Verbindungsvorrichtung gemäß Fig. 1, mit dem Gehäuseoberteil und dem Kontaktträger in der oberen Position,
- Fig. 7: eine Frontansicht eines Ausschnitts der Anschluss- und Verbindungsvorrichtung, in der Position gemäß Fig. 6,
- Fig. 8: zwei Frontansichten eines Ausschnitts der erfindungsgemäßen Anschluss- und Verbindungsvorrichtung, in der Position gemäß Fig. 4,
- Fig. 9: eine Frontansicht eines Ausschnitts der Anschluss- und Verbindungsvorrichtung, in der Position gemäß Fig. 5,
- Fig. 10: ein zweites Ausführungsbeispiel einer Anschluss- und Verbindungsvorrichtung, in einer die Anschlussleitung noch nicht kontaktierenden Position, perspektivisch mit teilweise weg geschnittenem Gehäuse und in Seitenansicht,
- Fig. 11: die Anschluss- und Verbindungsvorrichtung gemäß Fig. 10, in einer die Anschlussleitung kontaktierenden Position, perspektivisch mit teilweise weg geschnittenem Gehäuse und in Seitenansicht,
- Fig. 12: ein weiteres Ausführungsbeispiel einer Anschluss- und Verbindungsvorrichtung, in einer die Anschlussleitung kontaktierenden Position, mit teilweise weg geschnittenem Gehäuse,
- Fig. 13: eine Variante der Anschluss- und Verbindungsvorrichtung gemäß Fig. 12, in einer die Anschlussleitung noch nicht kontaktierenden Position, mit teilweise weggeschnittenem Gehäuse, und
- Fig. 14: zwei Varianten der Kontaktfeder, mit Metallteil und an der Kontaktfeder in der ersten Position gehaltenen Überfeder.
Die Figuren zeigen eine erfindungsgemäße Anschluss- und Verbindungsvorrichtung 1 bzw. Teile der Anschluss- und Verbindungsvorrichtung 1 für den elektrischen Anschluss eines ausschnittsweise dargestellten Solarmoduls 2. Die Anschluss- und Verbindungsvorrichtung 1, die nachfolgend auch als Anschlussdose bezeichnet wird, weist ein aus einem Gehäuseunterteil 3 und einem Gehäuseoberteil 4 bestehendes Gehäuse auf, das mit seinem Gehäuseunterteil 3 auf das Solarmodul 2 aufgesetzt werden kann.

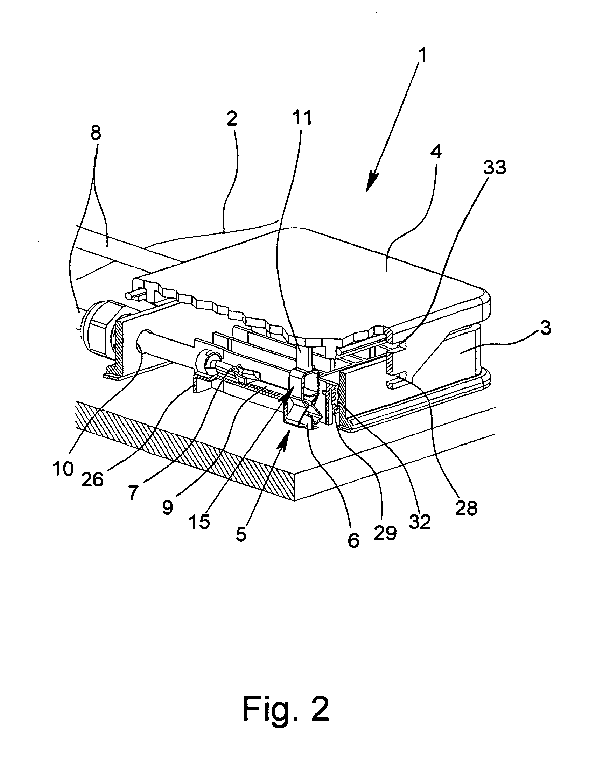

Innerhalb des Gehäuseunterteils 3 sind mehrere Kontaktfedern 5 angeordnet, die zur elektrischen Kontaktierung der als Flachleiter ausgebildeten Anschlussleitungen 6 des Solarmoduls 2 dienen. Darüber hinaus sind in dem Gehäuseunterteil 3 bei dem Ausführungsbeispiel gemäß den Figuren 2, 3, 7, 10 und 11 zwei als Crimp-Anschlüsse ausgebildete Anschlusselemente 7 angeordnet, über die zwei externe Kabel 8 angeschlossen sind. Jeweils eine Kontaktfeder 5 ist dabei über ein Metallteil 9 mit einem Anschlusselement 7 verbunden, so dass eine mittels der Kontaktfeder 5 kontaktierte Anschlussleitung 6 elektrisch leitend mit einem Kabel 8, das durch eine Öffnung 10 in das Innere des Gehäuseunterteils 3 eingeführt ist, verbunden werden kann.

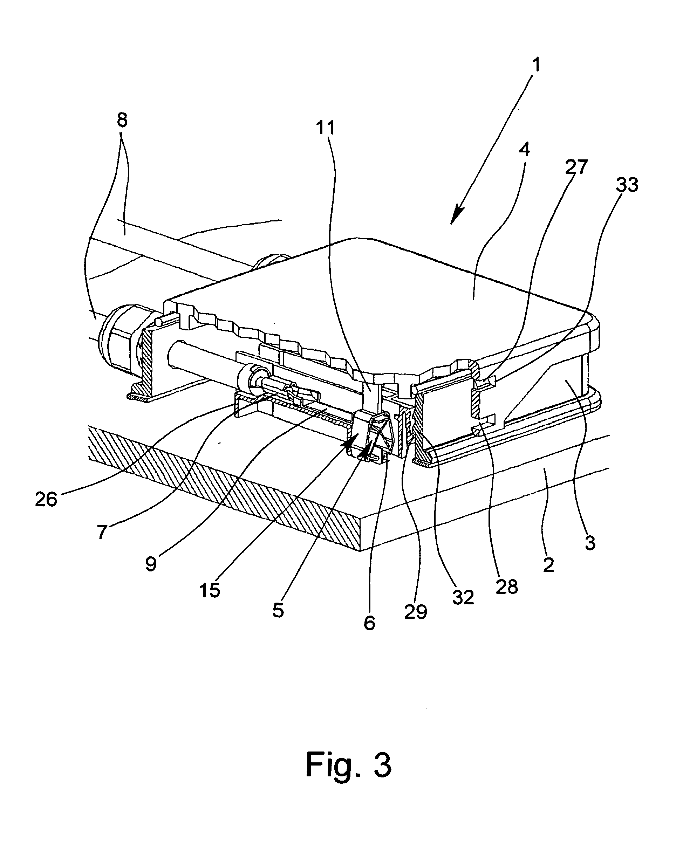

Aus den Fig. 2 bis 13 ist ersichtlich, dass an dem deckelförmigen Gehäuseoberteil 4 mehrere nach innen ragende Betätigungselemente 11 ausgebildet sind, mit deren Hilfe die Kontaktfeder 5 beim Aufdrücken des Gehäuseoberteils 4 auf das Gehäuseunterteil 3 aus einer ersten, eine Anschlussleitung 6 nicht kontaktierenden Position (Fig. 2, 4, 10, 13) in eine zweite Position verbringbar ist, in der die Anschlussleitung 6 von der Kontaktfeder 5 kontaktiert wird (Fig. 3, 5, 10, 12).

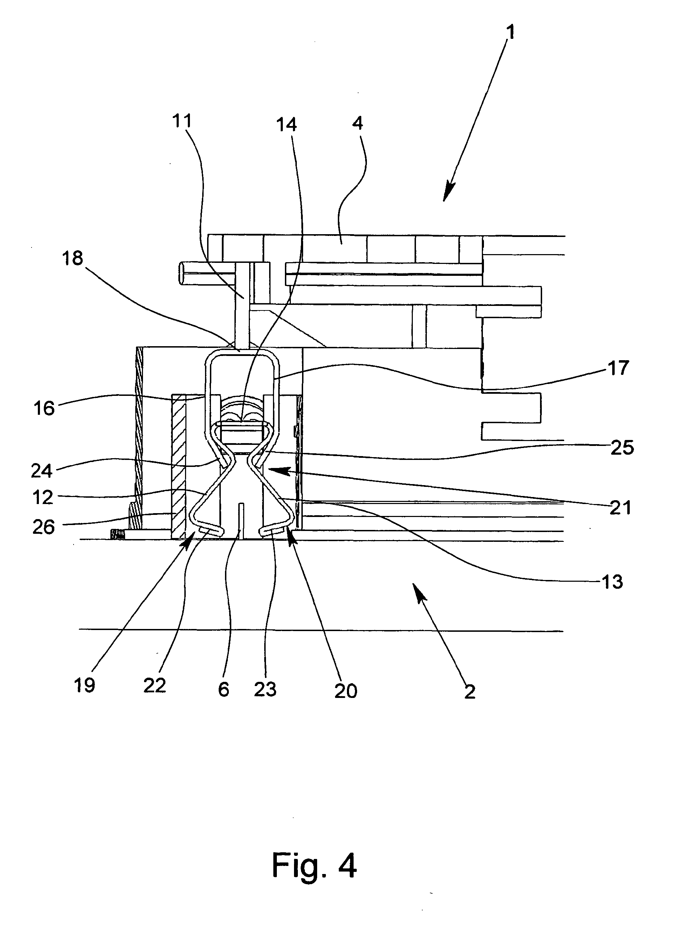

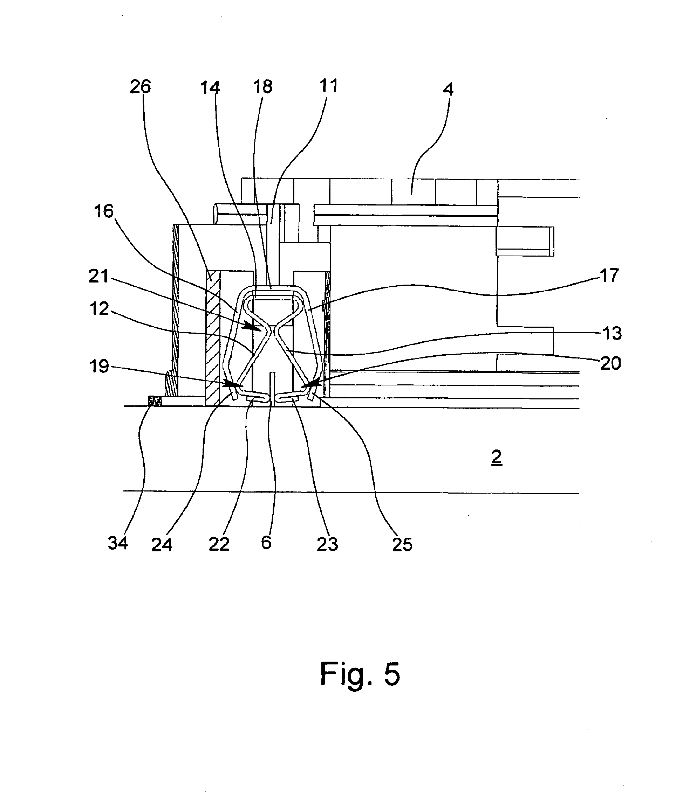

Insbesondere aus den vergrößerten Darstellungen gemäß den Fig. 4 und 5 sowie 7 und 8 ist erkennbar, dass die Kontaktfeder 5 zwei Kontaktschenkel 12, 13 und einen die Kontaktschenkel 12, 13 verbindenden Rücken 14 aufweist. Außerdem ist an der Kontaktfeder 5 eine Überfeder 15 verschiebbar angeordnet, die zwei Federschenkel 16, 17 und einen die Federschenkel 16, 17 verbindenden Rücken 18 aufweist. Die Endbereiche 19, 20 der Kontaktschenkel 12, 13 der Kontaktfeder 5 sind dabei derart aufeinander zu gebogen, dass die Endbereiche 19, 20 den Kontaktbereich der Kontaktfeder 5 bilden, wie insbesondere aus einem Vergleich der Fig. 4 und 5 ersichtlich ist. Darüber hinaus weist die Kontaktfeder 5 einen Bereich 21 auf, in dem die Kontaktschenkel 12, 13 - verglichen mit dem Rücken 14 - einen geringeren Abstand zueinander aufweisen. Hierzu sind die Kontaktschenkel 12, 13, ausgehend vom Rücken 14 bis zum Bereich 21 aufeinander zu und dann zu ihren Endbereichen 19, 20 hin wieder voneinander weg gebogen, wobei die Endbereiche 19, 20 jedoch wieder aufeinander zu gebogen sind.

Schließlich sind bei der in den Figuren dargestellten Kontaktfeder 5 die Enden 22, 23 der Kontaktschenkel 12, 13 jeweils zurück gebogen, so dass die Kontaktschenkel 12, 13 im Kontaktbereich der Kontaktfeder 5 gerundet ausgebildet sind. Hierdurch wird zum einen erreicht, dass die Kontaktschenkel 12, 13 im Kontaktbereich eine höhere Stabilität aufweisen, dass zum anderen der Kontaktbereich keine scharfen Kanten aufweist, so dass es beim Kontaktieren der Anschlussleitung 6 nicht zu einer Beschädigung der Anschlussleitung 6 kommt.

Die Überfeder 15 ist im Wesentlichen U-förmig ausgebildet, wobei jedoch die Enden 24, 25 der Federschenkel 16, 17 aufeinander zu gebogen, d. h. nach innen abgebogen sind, so dass der Abstand zwischen den Enden 24, 25 der Federschenkel 16, 17 geringer ist als der Abstand der Federschenkel 16, 17 in der Nähe des Rückens 18. Durch die zuvor beschriebene Ausgestaltung sowohl der Kontaktfeder 5 als auch der Überfeder 15 ist die Überfeder 15 auch in der ersten, in Fig. 4 dargestellten Position an der Kontaktfeder 5 gehalten. Die nach innen abgebogenen Enden 24, 25 der Federschenkel 16, 17 befinden sich dabei in dem Bereich 21, in dem die Kontaktschenkel 12, 13 der Kontaktfeder 5 einen geringeren Abstand zueinander aufweisen.

Wird das Gehäuseoberteil 4 auf das Gehäuseunterteil 3 aufgedrückt, so führt dies dazu, dass auch das einstückig mit dem Gehäuseoberteil 4 verbundene Betätigungselement 11 in Richtung auf das Gehäuseunterteil 3 bewegt wird. Dabei drückt das Betätigungselement 11 auf den Rücken 18 der Überfeder 15, wodurch die Überfeder 15 nach unten gedrückt wird. Hierbei schiebt sich die Überfeder 15 derart über die Kontaktfeder 5, das - in der in Fig. 5 dargestellten zweiten Position des Gehäuseoberteils 4 - die Kontaktschenkel 12, 13 der Kontaktfeder 5 durch die Federschenkel 16, 17 der Überfeder 15 so weit zusammengedrückt sind, dass die Kontaktschenkel 12, 13 eine zwischen ihnen eingeführte Anschlussleitung 6 klemmend kontaktieren. Um eine ausreichend hohe Kontaktkraft über die Kontaktfeder 5 auf die Anschlussleitung 6 aufzubringen, ist die Überfeder 15 so ausgelegt, dass sie im Vergleich zur Kontaktfeder 5 eine wesentlich größere Federkraft aufweist, so dass die Kontaktschenkel 12, 13 der Kontaktfeder 5 in der zweiten Position durch die Federschenkel 16, 17 der Überfeder 15 sicher und dauerhaft zusammengedrückt werden.

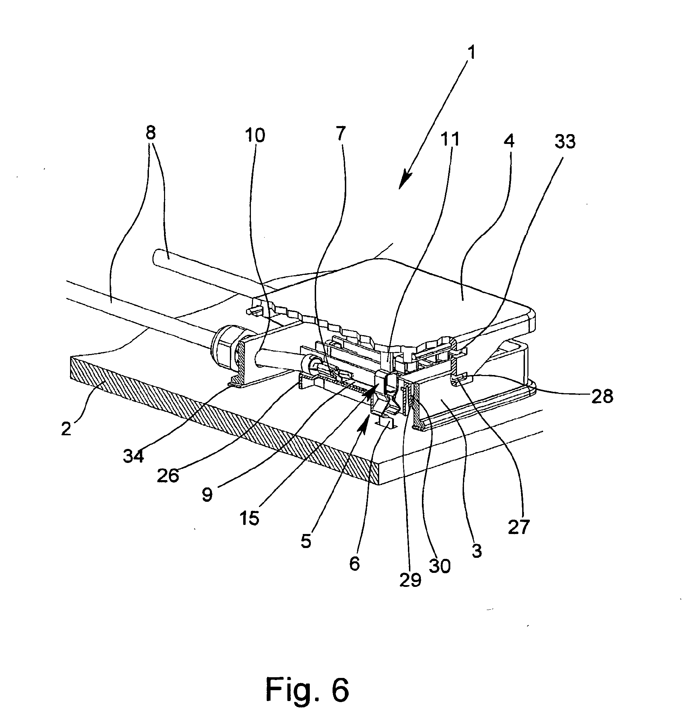

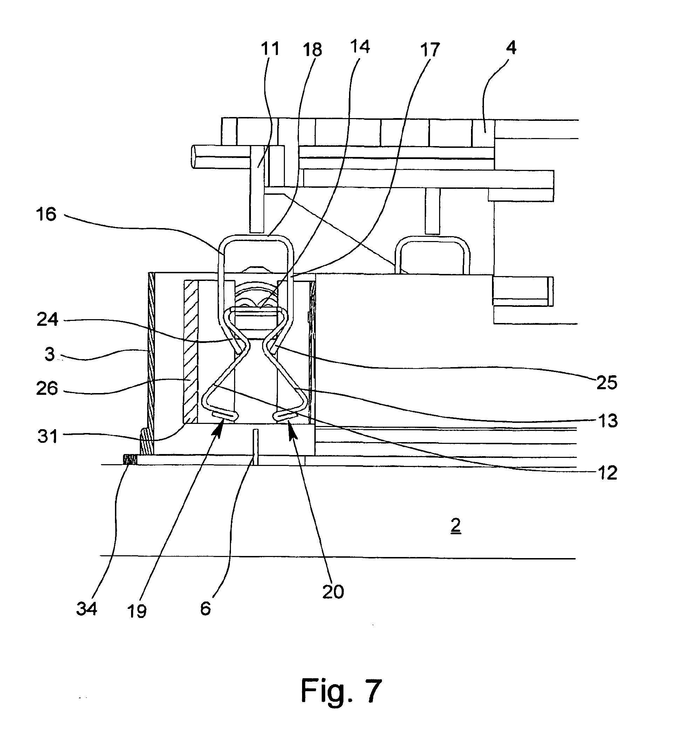

Bei dem ersten Ausführungsbeispiel ist das Metallteil 9 auf seiner einen Seite einstückig mit der Kontaktfeder 5 und auf seiner anderen Seite einstückig mit einem als Crimp-Anschluss ausgebildeten Anschlusselement 7 verbunden. Zur Aufnahme und Halterung des Metallteils 9 sowie eines mit dem Anschlusselement 7 verbundenen Endes des Kabels 8 ist in dem Gehäuseunterteil 3 ein Kontaktträger 26 aus Kunststoff angeordnet. Bei dem in den Figuren 2 bis 9 dargestellten Ausführungsbeispiel ist der Kontaktträger 26 derart beweglich mit dem Gehäuseunterteil 3 verbunden, dass der Kontaktträger 26 aus einer ersten, oberen Position (Fig. 6 und 7) in eine zweite, untere Position (z. B. Fig. 2 und 4) verbracht werden kann. Das "Herunterdrücken" des Kontaktträgers 26 erfolgt dabei ebenfalls automatisch durch Aufdrücken des Gehäuseoberteils 4 auf das Gehäuseunterteil 3, wie nachfolgend beschrieben wird.

In der in Fig. 6 und 7 dargestellten obersten Position des Gehäuseoberteils 4 befindet sich das Gehäuseoberteil 4 in einer ersten Gehäuseraststellung, in der eine am Gehäuseunterteil 3 ausgebildete Rastnase 27 in einer am Gehäuseoberteil 4 ausgebildeten unteren Rastausnehmung 28 eingerastet ist (Fig. 6). In dieser Position ist der Kontaktträger 26 ebenfalls in seiner oberen Position verrastet. Hierzu ist an der Stirnseite des Kontaktträgers 26 eine Rastnase 29 ausgebildet, die unter einem oberen Rastvorsprung 30 an der Innenseite des Gehäuseunterteils 3 eingerastet ist. In dieser Position weist die Unterseite 31 des Kontaktträgers 26 einen Abstand von Solarmodul 2 auf. Außerdem sind in dieser Position die Endbereiche 19, 20 der Kontaktschenkel 12, 13 der Kontaktfeder 5 oberhalb einer anzuschließenden Anschlussleitung 6 positioniert.

Wird das Gehäuseoberteil 4 nach unten, in Richtung auf das Gehäuseunterteil 3 gedrückt, so drückt das freie Ende des Betätigungselements 11 auf den darunter angeordneten Rücken 18 der Überfeder 15. Durch die zuvor beschriebene Anordnung der Überfeder 15 an der Kontaktfeder 5 wird zunächst die Kontaktfeder 5 - und damit auch der bewegliche Kontaktträger 26 - nach unten gedrückt, bis die Unterseite 31 des Kontaktträgers 26 auf dem Solarmodul 2 aufsitzt (Fig. 2 und 4). Dabei gleitet die Rastnase 29 des Kontaktträgers 26 entlang der Schräge eines zweiten, unteren Rastvorsprungs 32 an der Innenseite des Gehäuseunterteils 3, bis die Rastnase 29 hinter den Rastvorsprung 32 einrastet (Fig. 2). Die Position der Überfeder 15 relativ zur Kontaktfeder 5 hat sich dabei jedoch noch nicht verändert. Die Anschlussleitung 6 ist nun zwar zwischen den Endbereiche 19, 20 der Kontaktschenkel 12, 13 der Kontaktfeder 5 angeordnet, die Kontaktschenkel 12, 13 sind jedoch noch nicht durch die Überfeder 15 zusammengedrückt, so dass die Anschlussleitung 6 auch noch nicht kontaktiert ist.

Wird das Gehäuseoberteil 4 weiter auf das Gehäuseunterteil 3 aufgedrückt bzw. aufgeschoben, bis die Rastnase 27 am Gehäuseunterteil 3 in eine obere Rastausnehmung 33 am Gehäuseoberteil 4 einrastet (Fig. 3), so wird auch die Überfeder 15 weiter nach unten, in Richtung auf das Solarmodul 2 geschoben. Da der Kontaktträger 26 jedoch auf dem Solarmodul 2 aufsitzt - und somit nicht mehr weiter nach unten gedrückt werden kann - schiebt sich die Überfeder 15 nunmehr über die Kontaktfeder 5 wobei die Federschenkel 16, 17 entlang der Kontaktschenkel 12, 13 der Kontaktfeder 5 gleiten und dabei die Kontaktschenkel 12, 13 soweit zusammendrücken, dass sie die zwischen ihnen angeordnete Anschlussleitung 6 klemmend kontaktieren (Fig. 5).

In der in den Fig. 3 und 5 dargestellten zweiten Position der Kontaktfeder 5 bzw. der Überfeder 15 ist das Gehäuseoberteil 4 vollständig auf das Gehäuseunterteil 3 aufgedrückt, so dass das Gehäuse der Anschlussdose 1 geschlossen ist. In dieser Position sitzt die Überfeder 15 gespannt über der Kontaktfeder 5, so dass von der Überfeder 15 bzw. von den Federschenkel 16, 17 eine Kontaktkraft über die Kontaktschenkel 12, 13 auf die Anschlussleitung 6 aufgebracht wird. Wie insbesondere aus Fig. 5 ersichtlich ist, sind dabei die nach innen abgebogenen Enden 24, 25 der Federschenkel 16, 17 so weit auf die Kontaktschenkel 12, 13 aufgeschoben, dass eine Selbsthemmung realisiert ist, so dass die Überfeder 15 ohne Aufbringen einer externen Kraft nicht wieder zurück (nach oben) in Richtung ihrer ersten Position rutschen kann.

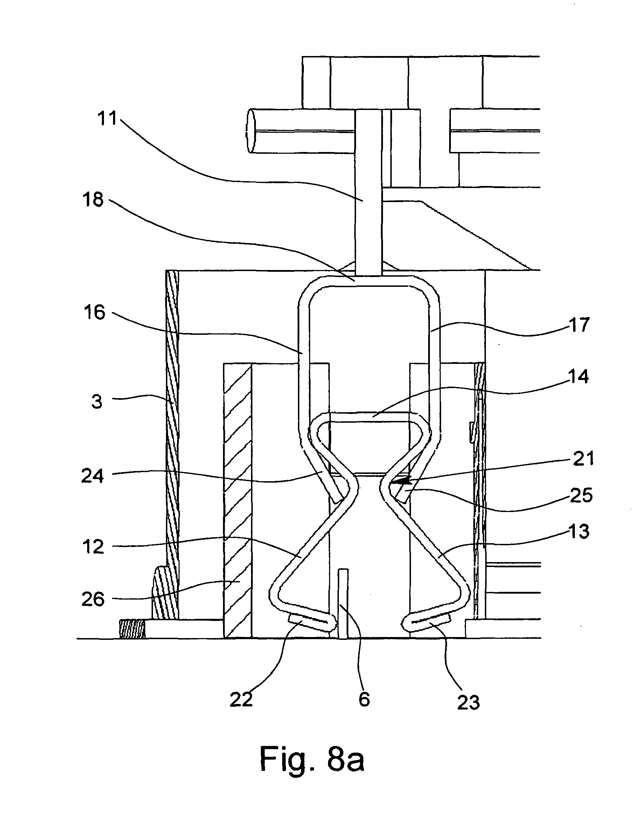

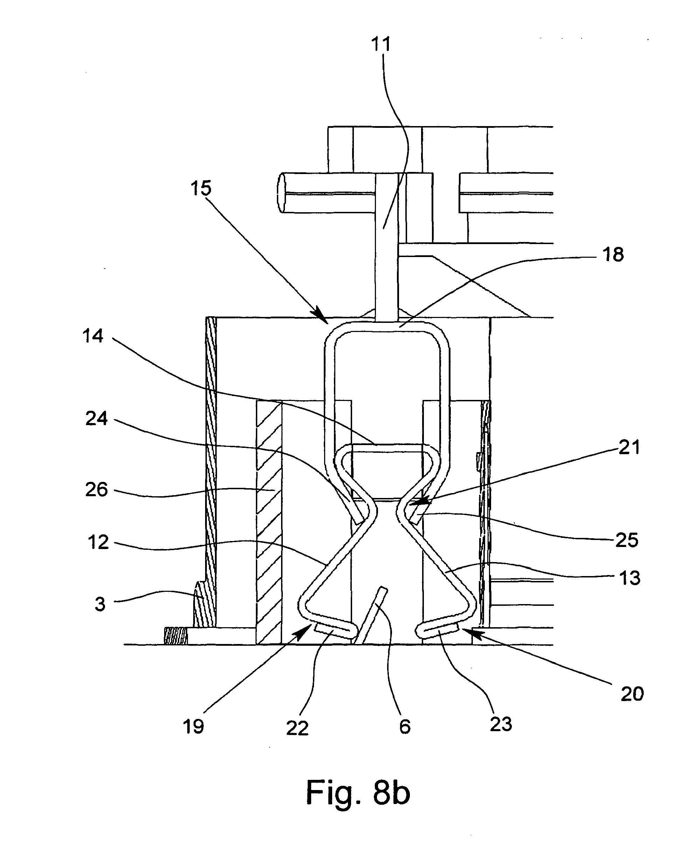

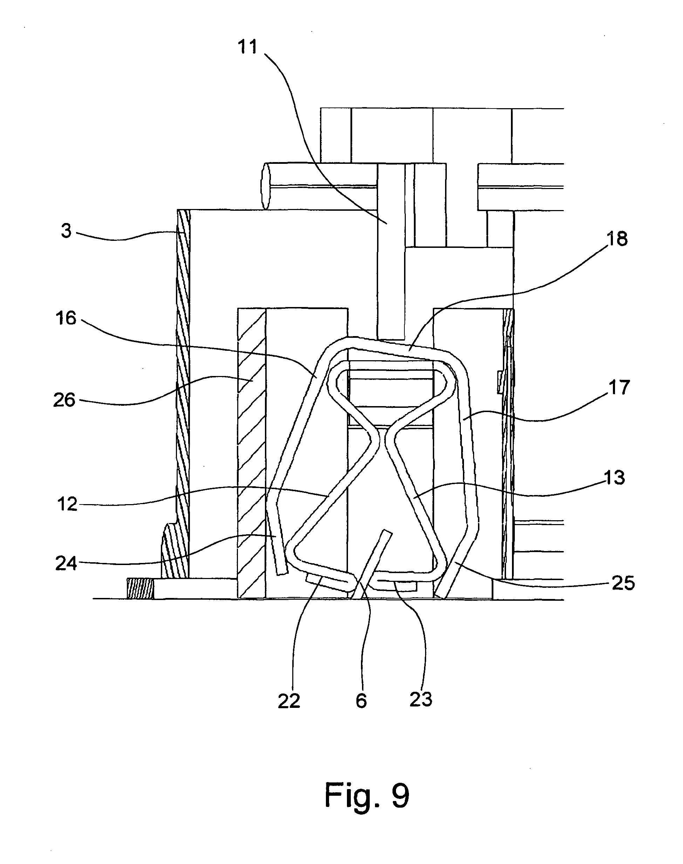

Aus den beiden Darstellungen in Fig. 8 ist ersichtlich, dass die erfindungsgemäße Anschlussdose 1 relativ unempfindlich gegenüber Positionstoleranzen der Anschlussleitungen 6 ist. Da die Kontaktfeder 5 beim Aufsetzen der Anschlussdose 1 auf das Solarmodul 2 geöffnet ist und dabei der Abstand zwischen den Endbereichen 19, 20 der Kontaktschenkel 12, 13 relativ groß ist, so dass die Kontaktfeder eine relativ breite Klemmstelle aufweist, können sowohl Anschlussleitungen 6, die seitlich versetzt zur "Normallage" angeordnet sind (Fig. 8a), als auch schräg vom Solarmodul 2 abstehende Anschlussleitungen 6 (Fig. 8b) sicher kontaktiert werden. Aus Fig. 9 ist dabei ersichtlich, wie die Kontaktfeder 5 auch eine schräg vom Solarmodul 2 abstehende Anschlussleitungen 6 sicher kontaktieren kann.

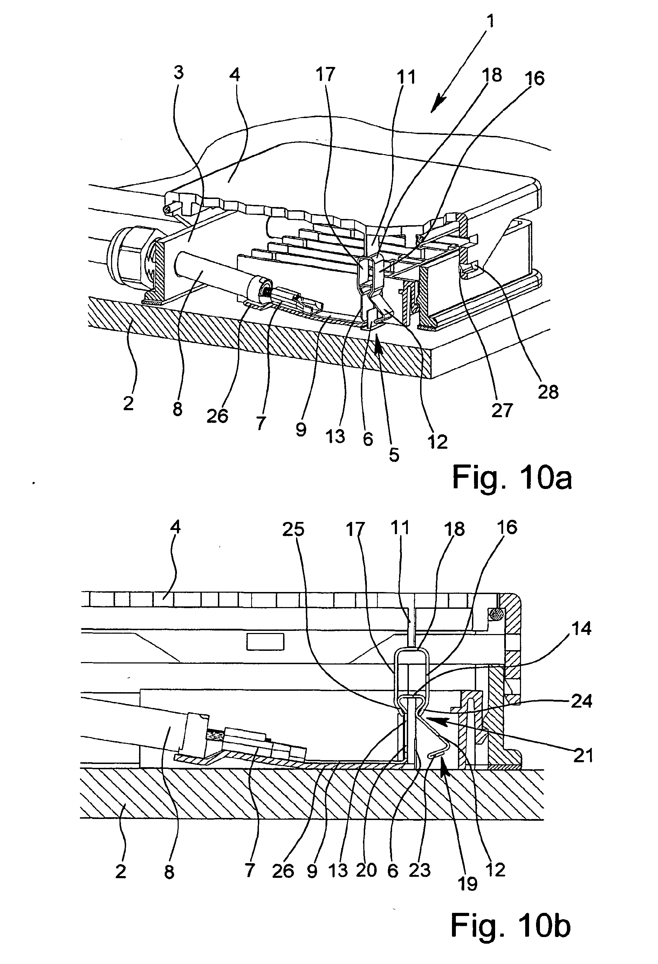

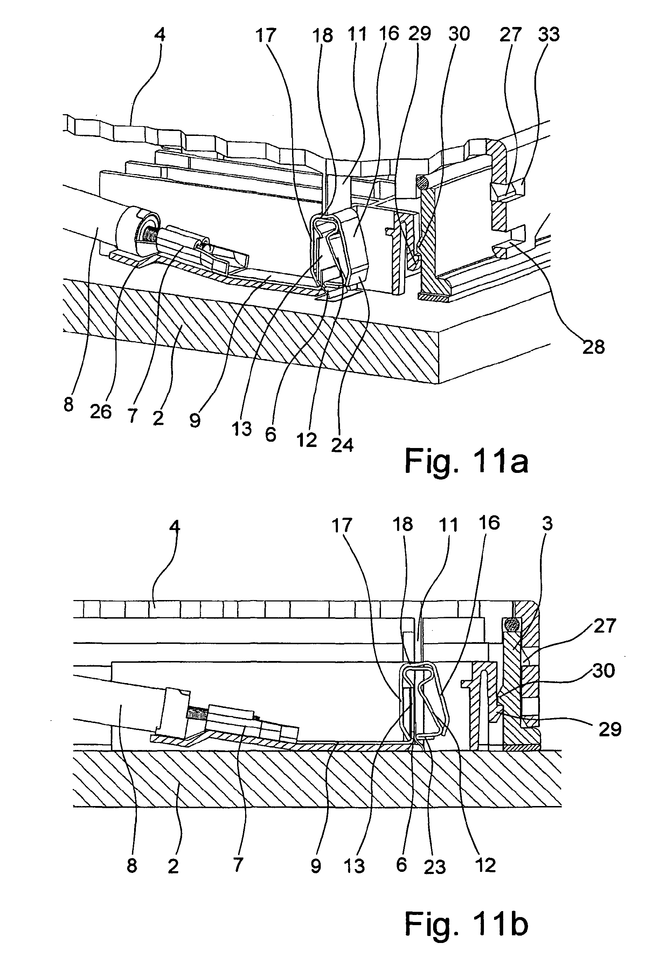

In den Figuren 10 und 11 ist ein zweites Ausführungsbeispiel einer erfindungsgemäßen Anschlussdose 1 dargestellt, wobei in Fig. 10 die Anschlussleitung 6 noch nicht kontaktiert ist, während in der Darstellung gemäß Fig. 11 die Anschlussleitung 6 von der Kontaktfeder 5 kontaktiert wird. Bei diesem Ausführungsbeispiel ist zunächst die Anschlussleitung 6 - im Vergleich zu dem zuvor beschriebenen Ausführungsbeispiel - um 90° gedreht aus dem Solarmodul 2 herausgeführt. Korrespondierend dazu sind auch die Kontaktfeder 5 und die Überfeder 15 um 90° gedreht im Gehäuseunterteil 3 angeordnet. Darüber hinaus unterscheidet sich dieses Ausführungsbeispiel der Anschlussdose 1 insbesondere durch eine etwas andere Ausgestaltung der Kontaktfeder 5.

Die in den Figuren 10 und 11 gezeigt Kontaktfeder 5 weist zwar ebenfalls zwei Kontaktschenkel 12, 13 und einen Rücken 14 auf, dabei ist jedoch nur ein Kontaktschenkel 12 federnd ausgebildet, während der andere Kontaktschenkel 13 starr ist. Der Endbereich 19 des federnden Kontaktschenkels 12 ist auch hier in Richtung auf den starren Kontaktschenkel 13 bzw. die Anschlussleitung 6 gebogen, wobei das Ende 22 des Kontaktschenkels 12 so zurück gebogen ist, dass der Kontaktschenkel 12 einen gerundeten Kontaktbereich aufweist. Das freie Ende des starren Kontaktschenkels 13 ist dagegen gerade ausgebildet und einstückig mit einem Ende des Metallteils 9 verbunden, an dessen anderem Ende ein Crimp-Anschluss als Anschlusselement 7 für das Kabel 8 ausgebildet ist.

Damit die Überfeder 15 auch in der ersten Position (Fig. 10) an der Kontaktfeder 5 gehalten ist, ist der federnde Kontaktschenkel 12, ausgehend vom Rücken 14 der Kontaktfeder 5, zunächst in Richtung auf den starren Kontaktschenkel 13 gebogen und dann zu seinem Endbereich 19 hin wieder vom starren Kontaktschenkel 13 weg gebogen. Auch diese Kontaktfeder 5 weist somit einen zwischen dem Rücken 14 und den Endbereichen 19, 20 der Kontaktschenkel 12, 13 angeordneten Bereich 21 auf, in dem die Kontaktschenkel 12, 13 einen geringeren Abstand zueinander haben. Dieser Bereich 21 dient zur Halterung der Überfeder 15, wozu die aufeinander zu gebogenen Enden 24, 25 ihrer Federschenkel 16, 17 den Rücken 14 der Kontaktfeder 5 übergreifen und in dem Bereich 21 der Kontaktfeder 5 enden.

Beim Herunterdrücken des Gehäuseoberteils 4 wird auch hierbei die Überfeder 15 durch das Betätigungselement 11 nach unten gedrückt. Dabei schiebt sich die Überfeder 15 derart über die Kontaktfeder 5, das - in der in Fig. 11 dargestellten zweiten Position des Gehäuseoberteils 4 - der federnde Kontaktschenkel 12 der Kontaktfeder 5 durch den Federschenkel 16 der Überfeder 15 so weit in Richtung auf den starren Kontaktschenkel 13 ausgelenkt wird, dass die Anschlussleitung 6 zwischen den Kontaktschenkeln 12, 13 klemmend kontaktiert wird. Ist die Anschlussleitung 6 etwas beabstandet vom starren Kontaktschenkel 13 angeordnet, so führt dies dazu, dass die Anschlussleitung 6 leicht abgebogen wird, was aufgrund der geringen Dicke der Anschlussleitung 6 jedoch unproblematisch ist. Da der starre Kontaktschenkel 13 in seinem Endbereich 20 einstückig mit dem Metallteil 9 verbunden ist, kann ein guter Stromübergang von der Anschlussleitung 6 über den starren Kontaktschenkel 13, das Metallteil 9 und das Anschlusselement 7 zum Kabel 8 erreicht werden.

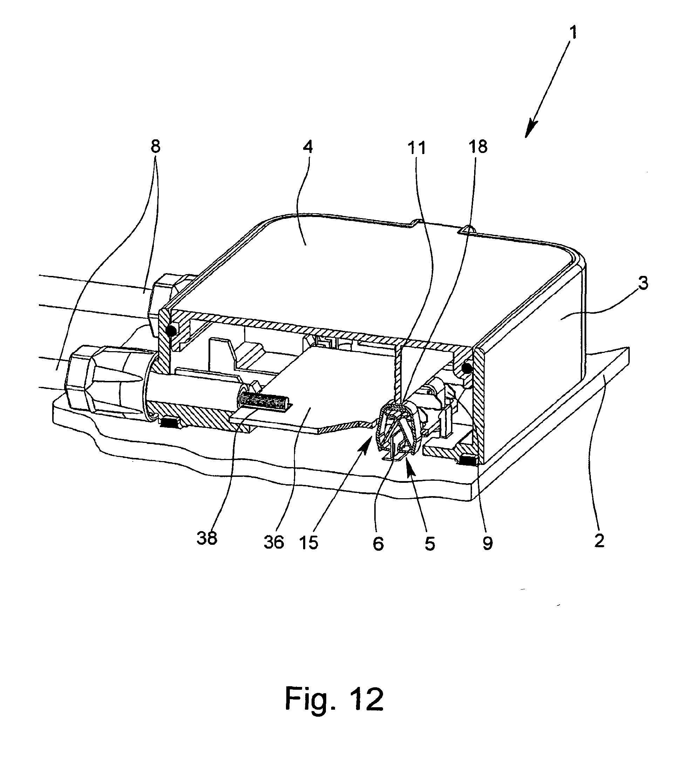

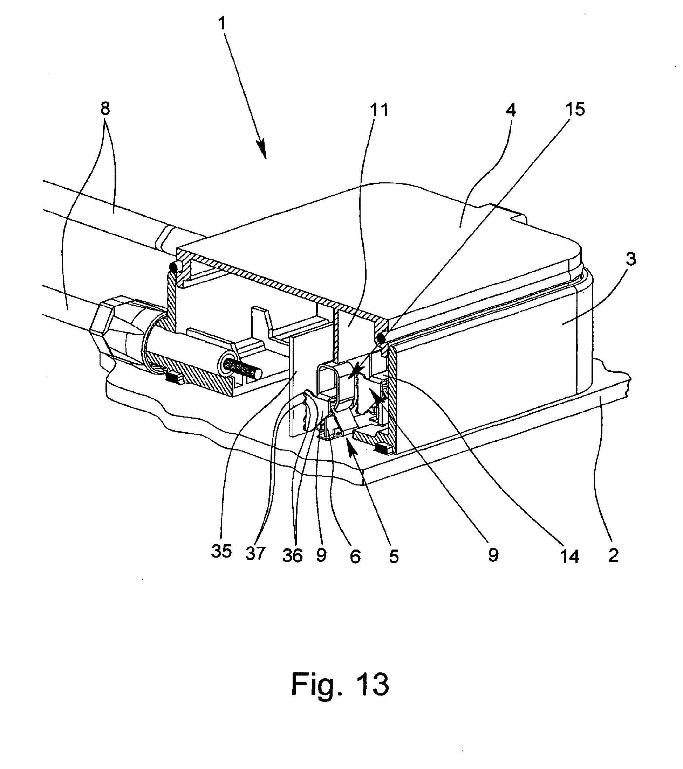

Bei der in den Fig. 12 und 13 dargestellten Ausführungsformen der Anschlussdose 1 ist das Metallteil 9 lediglich einstückig mit der Kontaktfeder 5 verbunden, während zwischen dem Metallteil 9 und dem freien Ende des Kabels 8 eine Leiterplatte 35 als weiteres Bauteil angeordnet ist. Die Verbindung zwischen dem Metallteil 9 und der Leiterplatte 35 erfolgt dabei über die am freien Ende des Metallteils 9 ausgebildeten Lötanschlusspins 36, die in korrespondierenden Bohrungen 37 in der Leiterplatte 35 eingesteckt und verlötet sind. Die elektrische Verbindung zwischen dem Kabel 8 und der Leiterplatte 35 erfolgt dadurch, dass das freie Ende des Kabels 8 auf einem auf der Leiterplatte 35 angeordneten Lötanschluss 38 angelötet ist. Die elektrische Verbindung zwischen der Anschlussleitung 6 und dem Kabel 8 erfolgt dann über die Kontaktfeder 5, das einstückig damit verbundene Metallteil 9 mit den Lötanschlusspins 36, die Bohrungen 37 und die Leiterplatte 35 mit dem Lötanschluss 38, wobei der Lötanschluss 38 mit mindestens einer Bohrung 37 über eine auf der Leiterplatte 35 ausgebildete, hier nicht dargestellte, Leiterbahn elektrisch verbunden ist.

Die in den Fig. 12 und 13 dargestellten Anschlussdosen 1 unterscheiden sich durch die unterschiedliche Anordnung und Ausrichtung der im Gehäuseunterteil 3 vorgesehenen Leiterplatte 35. Während bei der Anschlussdose 1 gemäß Fig. 12 die Leiterplatte 35 parallel zum Solarmodul 2, d.h. waagerecht angeordnet ist, ist die Leiterplatte 35 bei der Anschlussdose 1 gemäß Fig. 13 senkrecht zum Solarmodul 2 angeordnet. In Fig. 13 ist die elektrische Verbindung des freien Endes des Kabels 8 mit der Leiterplatte 35 nicht dargestellt; bei dieser Ausführungsvariante weist die Leiterplatte 35 entweder einen weiteren, waagerecht verlaufenden Abschnitt auf, an dem das Kabel 8 angelötet ist, oder an der Leiterplatte 35 ist eine Steckverbindung befestigt, an die das freie Endes des Kabels 8 angeschlossen wird.

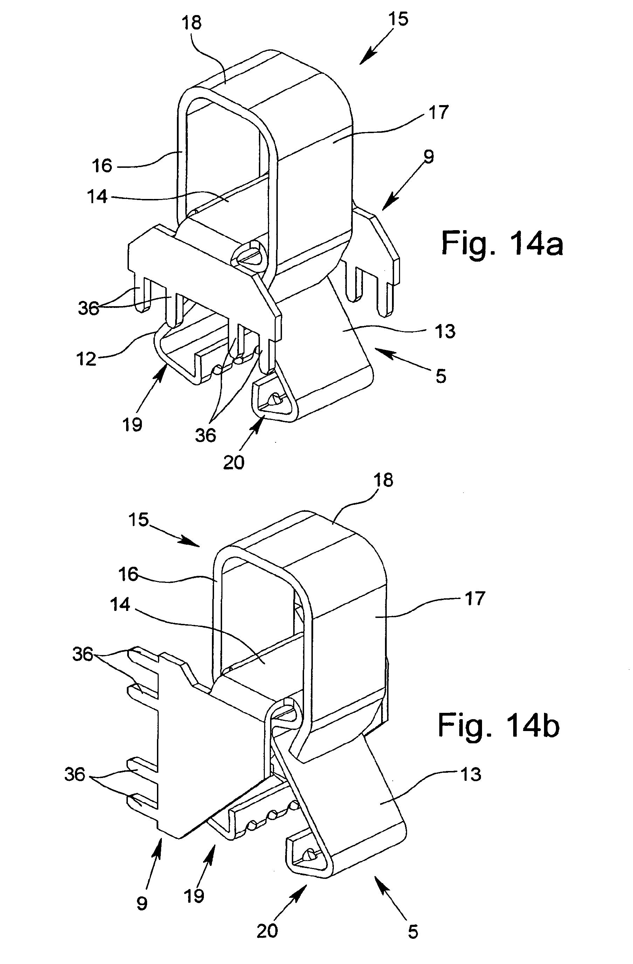

Korrespondierend zur Ausrichtung der Leiterplatte 35, mit der das Metallteil 9 verbunden wird, sind auch die Lötanschlusspins 36 des Metallteils 9 ausgerichtet, wie dies insbesondere in den beiden Darstellungen der Fig. 12 erkennbar ist. Das in Fig. 14a dargestellte Metallteil 9 ist bei der Anschlussdose 1 gemäß Fig. 12 und das in Fig. 14b dargestellte Metallteil 9 bei der Anschlussdose 1 gemäß Fig. 13 eingesetzt. In beiden Fällen ist das Metallteil 9 einstückig mit der Kontaktfeder 5, nämlich mit dem Rücken 14 verbunden, so dass die Kontaktfeder 5 und das Metallteil 9 als ein Stanz- und Biegeteil hergestellt werden kann.

Wie zuvor im Einzelnen beschriebenen worden ist, kann mit der erfindungsgemäßen Anschlussdose 1 auf einfache Art und Weise eine sichere, dauerhafte elektrische Verbindung zwischen den Anschlussleitungen 6 eines Solarmoduls 2 und den in die Anschlussdose 1 eingeführten Kabeln 8 hergestellt werden, indem die Anschlussdose 1 einfach auf die Seite des Solarmoduls 2 aufgesetzt wird, aus der die Anschlussleitungen 6 herausragen. Durch eine an der Unterseite des Gehäuseunterteils 3 angeordnete Klebstoffschicht 34 wird das Gehäuse beim Aufsetzen auf das Solarmodul 2 gleichzeitig an diesem befestigt. Dabei ist das Gehäuseoberteil 4 bereits beim Aufsetzen der Anschlussdose 1 auf das Solarmodul 2 mit dem Gehäuseunterteil 3 verbunden, nämlich in der oberen Gehäuserastposition verrastet. Anschließend muss nur noch das als Deckel dienende Gehäuseoberteil 4 auf das rahmenartige Gehäuseunterteil 3 vollständig aufgedrückt werden, bis das Gehäuseoberteil 4 in der zweiten Gehäuserastposition verrastet, in der die Anschlussleitungen 6 kontaktiert und das Gehäuse dicht verschlossen ist.

## Patentansprüche

1. Anschluss- und Verbindungsvorrichtung für den elektrischen Anschluss eines elektrischen Geräts, insbesondere eines Solarmoduls (2), mit einem ein Gehäuseunterteil (3) und ein Gehäuseoberteil (4) aufweisenden Gehäuse, mit mindestens einer Kontaktfeder (5) zur elektrischen Kontaktierung mindestens einer vom elektrischen Gerät kommenden Anschlussleitung (6), mit mindestens einem in dem Gehäuse angeordneten Anschlusselement (7) zum Anschluss mindestens eines Kabels (8), und mit mindestens einem Metallteil (9) über das eine durch die Kontaktfeder (5) kontaktierte Anschlussleitung (6) mit einem durch das Anschlusselement (7) angeschlossenen Kabel (8) elektrisch leitend verbindbar ist, wobei das Gehäuse mindestens eine Öffnung (10) zum Einführen des Kabels (8) aufweist, wobei die Kontaktfeder (5), das Anschlusselement (7) und das Metallteil (9) dem Gehäuseunterteil (3) zugeordnet sind und am Gehäuseoberteil (4) mindestens ein Betätigungselement (11) angeordnet ist, und wobei die Kontaktfeder (5) beim Aufsetzen bzw. Aufdrücken des Gehäuseoberteils (4) auf das Gehäuseunterteil (3) aus einer ersten Position, in der die Kontaktfeder (5) die Anschlussleitung (6) nicht kontaktiert, in eine zweite Position verbringbar ist, in der die Anschlussleitung (6) von der Kontaktfeder (5) kontaktiert ist,
**dadurch gekennzeichnet,**
**dass** die Kontaktfeder (5) zwei Kontaktschenkeln (12, 13) und einen die Kontaktschenkel (12, 13) verbindenden Rücken (14) aufweist,
**dass** eine Überfeder (15) vorgesehen ist, die zwei Federschenkel (16, 17) und einen die Federschenkel (16, 17) verbindenden Rücken (18) aufweist, wobei beim Aufsetzen bzw. Aufdrücken des Gehäuseoberteils (4) auf das Gehäuseunterteil (3) das Betätigungselement (11) auf den Rücken (18) der Überfeder (15) drückt, so dass die Überfeder (15) aus einer ersten Position in eine zweite Position verbracht wird, und
**dass** die Überfeder (15) derart ausgebildet und relativ zur Kontaktfeder (5) verschiebbar angeordnet ist, dass die Position mindestens eines Kontaktschenkels (12, 13) der Kontaktfeder (5) durch die Überfeder (15) so verändert wird, dass die Anschlussleitung (6) zwischen den beiden Kontaktschenkel (12, 13) klemmend kontaktiert ist.

2. Anschluss- und Verbindungsvorrichtung nach Anspruch 1, **dadurch gekennzeichnet, dass** beide Kontaktschenkel (12, 13) der Kontaktfeder (5) federnd ausgebildet sind, und dass die Überfeder (15) derart ausgebildet und relativ zur Kontaktfeder (5) verschiebbar angeordnet ist, dass die beiden Kontaktschenkel (12, 13) der Kontaktfeder (5) in der zweiten Position der Überfeder (15) von den beiden Federschenkeln (16, 17) der Überfeder (15) so zusammengedrückt werden, dass die Anschlussleitung (6) zwischen den beiden Kontaktschenkel (12, 13) klemmend kontaktiert ist,

3. Anschluss- und Verbindungsvorrichtung nach Anspruch 2, **dadurch gekennzeichnet, dass** die Endbereiche (19, 20) der Kontaktschenkel (12, 13) aufeinander zu gebogen sind, so dass die Endbereiche (19, 20) den Kontaktbereicht der Kontaktfeder (5) bilden, wobei die Enden (22, 23) der Kontaktschenkel (12, 13) vorzugsweise jeweils zurück gebogen sind, insbesondere um mehr als 90°, so dass die Kontaktschenkel (12, 13) gerundete Kontaktbereiche ausbilden.

4. Anschluss- und Verbindungsvorrichtung nach Anspruch 3, **dadurch gekennzeichnet, dass** die Kontaktschenkel (12, 13), ausgehend vom Rücken (14) der Kontaktfeder (5), zunächst aufeinander zu und dann zu ihren Endbereichen (19, 20) hin wieder voneinander weg gebogen sind, so dass die Kontaktfeder (5) einen zwischen dem Rücken (14) und den Endbereichen (19, 20) der Kontaktschenkel (12, 13) angeordneten Bereich (21) aufweist, in dem die Kontaktschenkel (12, 13) einen geringeren Abstand zueinander haben.

5. Anschluss- und Verbindungsvorrichtung nach Anspruch 1, **dadurch gekennzeichnet, dass** nur ein Kontaktschenkel (12) der Kontaktfeder (5) federnd ausgebildet ist, und dass die Überfeder (15) derart ausgebildet und relativ zur Kontaktfeder (5) verschiebbar angeordnet ist, dass der federnde Kontaktschenkels (12) der Kontaktfeder (5) durch der Überfeder (15) in Richtung auf den starren Kontaktschenkel (13) gedrückt wird, dass die Anschlussleitung (6) zwischen den beiden Kontaktschenkel (12, 13) klemmend kontaktiert ist.

6. Anschluss- und Verbindungsvorrichtung nach Anspruch 5, **dadurch gekennzeichnet, dass** der Endbereich (19) des federnden Kontaktschenkels (12) in Richtung auf den starren Kontaktschenkel (13) gebogen ist, wobei das Ende (22) des Kontaktschenkels (12) vorzugsweise zurück gebogen ist, so dass der Kontaktschenkel (12) einen gerundeten Kontaktbereich aufweist.

7. Anschluss- und Verbindungsvorrichtung nach Anspruch 6, **dadurch gekennzeichnet, dass** der federnde Kontaktschenkel (12), ausgehend vom Rücken (14) der Kontaktfeder (5), zunächst in Richtung auf den starren Kontaktschenkel (13) gebogen und dann zu seinem Endbereich (19) hin wieder vom starren Kontaktschenkel (13) weg gebogen ist, so dass die Kontaktfeder (5) einen zwischen dem Rücken (14) und den Endbereichen (19, 20) der Kontaktschenkeln (12, 13) angeordneten Bereich (21) aufweist, in dem die Kontaktschenkel (12, 13) einen geringeren Abstand zueinander haben.

8. Anschluss- und Verbindungsvorrichtung nach Anspruch 4 oder 7, **dadurch gekennzeichnet, dass** die Enden (24, 25) der Federschenkel (16, 17) der Überfeder (15) aufeinander zu gebogen sind, und dass die Überfeder (15) vor dem Aufsetzen bzw. Aufdrücken des Gehäuseoberteils (4) auf das Gehäuseunterteil (3) mit ihren Enden (24, 25) den Rücken (14) der Kontaktfeder (5) übergreift und in dem Bereich (21), in dem die Kontaktschenkel (12, 13) der Kontaktfeder (5) einen geringeren Abstand zueinander haben, enden.

9. Anschluss- und Verbindungsvorrichtung nach einem der Ansprüche 1 bis 8, **dadurch gekennzeichnet, dass** mindestens ein Kontaktträger (26) aus isolierendem Material mit dem Gehäuseunterteil (3) verbunden ist, in dem das mindestens eine Metallteil (9) gehalten ist.

10. Anschluss- und Verbindungsvorrichtung nach Anspruch 9, **dadurch gekennzeichnet, dass** der Kontaktträger (26) derart beweglich mit dem Gehäuseunterteil (3) verbunden ist, dass der Kontaktträger (26) beim Aufsetzen bzw. Aufdrücken des Gehäuseoberteils (4) auf das Gehäuseunterteil (3) aus einer ersten Position in eine zweite Position verbringbar ist, wobei die Endbereiche (19, 20) der Kontaktschenkel (12, 13) der Kontaktfeder (5) in der ersten Position des Kontaktträgers (26) auch bei auf das elektrische Gerät aufgesetztem Gehäuseunterteil (3) oberhalb einer anzuschließenden Anschlussleitung (6) positioniert sind, während die Anschlussleitung (6) in der zweiten Position des Kontaktträgers (26) zwischen den Endbereichen (19, 20) der Kontaktschenkel (12, 13) der Kontaktfeder (5) angeordnet ist,

11. Anschluss- und Verbindungsvorrichtung nach Anspruch 10, **dadurch gekennzeichnet, dass** zwischen dem Gehäuseunterteil (3) und dem Kontaktträger (26) zwei Verrastungen (29, 30, 32) ausgebildet sind, durch die der Kontaktträger (26) sowohl in seiner ersten Position als auch in seiner zweiten Position fixierbar ist.

12. Anschluss- und Verbindungsvorrichtung nach einem der Ansprüche 1 bis 8, **dadurch gekennzeichnet, dass** das Metallteil (9) direkt, insbesondere einstückig, mit der Kontaktfeder (5) und über ein weiteres Bauteil, insbesondere eine Leiterplatte (35) oder ein Leadframe, indirekt mit dem Anschlusselement (7) verbunden ist.

13. Anschluss- und Verbindungsvorrichtung nach Anspruch 12, **dadurch gekennzeichnet, dass** das Metallteil (9) an seinem freien, nicht mit der Kontaktfeder (5) verbundenen Ende mindestens einen Lötanschlusspin (36) aufweist, über den das Metallteil (9) mit dem weiteren Bauteil verbunden ist,

14. Anschluss- und Verbindungsvorrichtung nach einem der Ansprüche 1 bis 13, **dadurch gekennzeichnet, dass** zwischen dem Gehäuseunterteil (3) und dem Gehäuseoberteil (4) zwei Verrastungen (27, 28, 33) ausgebildet sind, durch die das Gehäuseunterteil (3) und das Gehäuseoberteil (4) sowohl in der ersten Position als auch in der zweiten Position zueinander fixierbar sind.

15. Anschluss- und Verbindungsvorrichtung nach einem der Ansprüche 1 bis 14, **dadurch gekennzeichnet, dass** das Gehäuseunterteil (3) als Gehäuserahmen mit offenem Boden und das Gehäuseoberteil (4) als Deckel ausgebildet ist.

16. Anschluss- und Verbindungsvorrichtung nach einem der Ansprüche 1 bis 15, **dadurch gekennzeichnet, dass** zwei Kontaktfedern (5), zwei Anschlusselemente (7), zwei Metallteile (9) und zwei Überfedem (15) vorgesehen sind und dass beide Metallteile (9) über eine Freilaufdiode verbunden sind.

## Claims

1. Joining and connecting device for electrical connection of an electrical device, especially a solar module (2), with a housing which has a housing lower part (3) and a housing upper part (4), with at least one contact spring (5) for making electrical contact with at least one terminal lead (6) arrinving from the electrical device, with at least one terminal element (7) located in the housing for connecting at least one cable (8) and with at least one metal part (9) via which a terminal lead (6) contacted by the contact spring (5) can be connected to a cable (8) connected by the terminal element (7) in an electrical conductive manner, wherein the housing having at least one opening (10) for inserting the cable (8), wherein the contact spring (5), the terminal element (7) and the metal part (9) are associated with the housing lower part (3) and at least one actuating element (11) is arranged on the housing upper part (4), and wherein, when the housing upper part (4) is mounted or pushed onto the housing lower part (3), the contact spring (5) can be moved out of a first position, in which the contact spring (5) does not make contact with the terminal lead (6), into a second position, in which the terminal lead (6) makes contact with the contact spring (5),
**characterized in**
**that** the contact spring (5) has two contact legs (12, 13) and a back (14) which connects the contact legs (12, 13),
**that** a top spring (15) is provided, which has two spring legs (16, 17) and a back (18) which connects the spring legs (16, 17), wherein, when the housing upper part (4) is mounted or pushed onto the housing lower part (3) the actuating element (11) pressing on the back (18) of the top spring (15) such that the top spring (15) is moved out of a first position into a second position, and that the top spring (15) is formed and arranged in a displaceable manner relative to the contact spring (5) such that the position of at least one contact leg (12, 13) of the contact spring (5) is changed by the top spring (15) such that the terminal lead (6) is contacted by clamping between the two contact legs (12,13).

2. Joining and connecting device according to Claim 1, wherein the two contact legs (12, 13) of the contact spring (5) are made elastic, and wherein the top spring (15) is formed and arranged in a displaceable manner relative to the contact spring (5) such that the two contact legs (12, 13) of the contact spring (5) in the second position of the top spring (15) are compressed by the two spring legs (16, 17) of the top spring (15) such that the terminal lead (6) is contacted by clamping between the two contact legs (12, 13).

3. Joining and connecting device according to Claim 2, wherein the end regions (19, 20) of the contact legs (12, 13) are bent toward one another so that the end regions (19, 20) form the contact region of the contact spring (5), wherein the ends (22, 23) of the contact legs (12, 13) preferably are each bent back, especially by more than 90°, so that the contact legs (12, 13) form rounded contact regions.

4. Joining and connecting device according to Claim 3, wherein the contact legs (12, 13), proceeding from the back (14) of the contact spring (5), are first bent toward one another and then again away from one another toward their end regions (19, 20) so that the contact spring (5) has a region (21) located between the back (14) and the end regions (19, 20) of the contact legs (12, 13) in which the contact legs (12, 13) have a shorter distance from one another.

5. Joining and connecting device according to Claim 1, wherein only one contact leg (12) of the contact spring (5) is made elastic, and wherein the top spring (15) is formed and arranged in a displaceable manner relative to the contact spring (5) such that the elastic contact leg (12) of the contact spring (5) is pressed by the top spring (15) in the direction to the rigid contact leg (13), wherein the terminal lead (6) is contacted by clamping between the two contact legs (12, 13).

6. Joining and connecting device according to Claim 5, wherein the end region (19) of the elastic contact leg (12) is bent in the direction to the rigid contact leg (13), wherein the end (22) of the contact leg (12) preferably being bent back so that the contact leg (12) has a rounded contact region.

7. Joining and connecting device according to Claim 6, wherein the elastic contact leg (12), proceeding from the back (14) of the contact spring (5), is bent first in the direction to the rigid contact leg (13) and then bent again away from the rigid contact leg (13) towards its end region (19), so that the contact spring (5) has a region (21) which is located between the back (14) and the end regions (19, 20) of the contact legs (12, 13), in which the contact legs (12, 13) have a shorter distance from one another.

8. Joining and connecting device according to Claim 4 or 7, wherein the ends (24, 25) of the spring legs (16, 17) of the top spring (15) are bent toward one another and wherein, before the housing upper part (4) is seated or pressed onto the housing bottom part (3), the top spring (15) overlaps with its ends (24, 25) the back (14) of the contact spring (5) and ends in the region (21) in which the contact legs (12, 13) of the contact spring (5) have a shorter distance to one another.

9. Joining and connecting device according to any one of Claims 1 to 8, wherein at least one contact carrier (26) of insulating material is connected to the housing lower part (3), in which at least one of the metal parts (9) is held.

10. Joining and connecting device according to Claim 9, wherein the contact carrier (26) is movably connected to the housing lower part (3) such that when the housing upper part (4) is seated or pressed onto the housing bottom part (3) the contact carrier (3) can be moved out of a first position into a second position, wherein, in the first position of the contact carrier (26), the end regions (19, 20) of the contact legs (12, 13) of the contact spring (5) being positioned above a terminal lead (6) which is to be connected even when the housing lower part (3) is seated on the electrical device, while in the second position of the contact carrier (26) the terminal lead (6) is located between the end regions (19, 20) of the contact legs (12, 13) of the contact spring (5).

11. Joining and connecting device according to Claim 10, wherein two catches (29, 30, 32) are formed between the housing lower part (3) and the contact carrier (26), by which catches the contact carrier (26) can be fixed both in its first position and also in its second position.

12. Joining and connecting device according to any one of Claims 1 to 8, wherein the metal part (9) is connected directly, especially integrally to the contact spring (5) and via another component, especially a circuit board (35) or a lead frame, indirectly to the terminal element (7).

13. Joining and connecting device according to Claim 12, wherein the metal part (9) on its free end which is not connected to the contact spring (5) has at least one solder terminal pin (36), via which the metal part (9) is connected to the other component.

14. Joining and connecting device according to any one of Claims 1 to 13, wherein two catches (27, 28, 33) are formed between the housing lower part (3) and the housing upper part (4), by which catches the housing lower part (3) and the housing upper part (4) can be fixed both in the first position and also in the second position to one another.

15. Joining and connecting device according to any one of Claims 1 to 14, wherein the housing lower part (3) is made as a housing frame with an open bottom and the housing upper part (4) is made as a cover.

16. Joining and connecting device according to any one of Claims 1 to 15, wherein there are two contact springs (5), two terminal elements (7), two metal parts (9) and two top springs (15) and wherein the two metal parts (9) are connected via a free-wheeling diode.

## Revendications

1. Dispositif de raccordement et de connexion pour le raccordement électrique d'un appareil électrique, notamment d'un module solaire (2), comprenant un boîtier qui présente une partie inférieure de boîtier (3) et une partie supérieure de boîtier (4), comprenant au moins un ressort de contact (5) pour établir le contact électrique avec au moins une ligne de raccordement (6) provenant de l'appareil électrique, comprenant au moins un élément de raccordement (7) disposé dans le boîtier pour raccorder au moins un câble (8) et comprenant au moins une pièce métallique (9) par le biais de laquelle une ligne de raccordement (6) mise en contact par le ressort de contact (5) peut être reliée électriquement avec un câble (8) raccordé par l'élément de raccordement (7), le boîtier présentant au moins une ouverture (10) pour introduire le câble (8), le ressort de contact (5), l'élément de raccordement (7) et la pièce métallique (9) étant associés à la partie inférieure de boîtier (3) et au moins un élément d'actionnement (11) étant disposé sur la partie supérieure de boîtier (4), et le ressort de contact (5), lors de la mise en place ou de l'enfoncement de la partie supérieure de boîtier (4) sur la partie inférieure de boîtier (3), pouvant être amené d'une première position, dans laquelle le ressort de contact (5) n'établit pas le contact avec la ligne de raccordement (6), dans une deuxième position dans laquelle la ligne de raccordement (6) est mise en contact par le ressort de contact (5),
**caractérisé en ce**
**que** le ressort de contact (5) présente deux branches de contact (12, 13) et un dos (14) qui relie les branches de contact (12, 13),
**qu'**il est prévu un haut de ressort (15) qui présente deux branches de ressort (16, 17) et un dos (18) qui relie les branches de ressort (16, 17), l'élément d'actionnement (11), lors de la mise en place ou de l'enfoncement de la partie supérieure de boîtier (4) sur la partie inférieure de boîtier (3), poussant sur le dos (18) du haut de ressort (15) de sorte que le haut de ressort (15) soit amené d'une première position dans une deuxième position et
en ce que le haut de ressort (15) est configuré et disposé de manière à pouvoir coulisser par rapport au ressort de contact (5) de telle sorte que la position d'au moins une branche de contact (12, 13) du ressort de contact (5) est modifiée par le haut de ressort (15) de telle sorte que la ligne de raccordement (6) est mise en contact en étant coincée entre les deux branches de contact (12, 13).

2. Dispositif de raccordement et de connexion selon la revendication 1, **caractérisé en ce que** les deux branches de contact (12, 13) du ressort de contact (5) sont réalisées flexibles et **en ce que** le haut de ressort (15) est configuré et disposé de manière à pouvoir coulisser par rapport au ressort de contact (5) de telle sorte que les deux branches de contact (12, 13) du ressort de contact (5), dans la deuxième position du haut de ressort (15), sont compressées par les deux branches de ressort (16, 17) du haut de ressort (15) de telle sorte que la ligne de raccordement (6) est mise en contact en étant coincée entre les deux branches de contact (12, 13).

3. Dispositif de raccordement et de connexion selon la revendication 2, **caractérisé en ce que** les zones d'extrémité (19, 20) des branches de contact (12, 13) sont coudées l'une vers l'autre, de sorte que les zones d'extrémité (19, 20) forment la zone de contact du ressort de contact (5), les extrémités (22, 23) des branches de contact (12, 13) étant de préférence à chaque fois coudées vers l'arrière, notamment de plus de 90°, de sorte que les branches de contact (12, 13) forment des zones de contact arrondies.

4. Dispositif de raccordement et de connexion selon la revendication 3, **caractérisé en ce que** les branches de contact (12, 13), en partant du dos (14) du ressort de contact (5), sont tout d'abord coudées l'une vers l'autre et ensuite de nouveau en s'éloignant l'une de l'autre vers leurs zones d'extrémité (19, 20), de sorte que le ressort de contact (5) présente une zone (21) disposée entre le dos (14) et les zones d'extrémité (19, 20) des branches de contact (12, 13) dans laquelle les branches de contact (12, 13) présentent un espacement plus faible l'une de l'autre.

5. Dispositif de raccordement et de connexion selon la revendication 1, **caractérisé en ce qu'**une seule branche de contact (12) du ressort de contact (5) est réalisée flexible, et **en ce que** le haut de ressort (15) est configuré et disposé de manière à pouvoir coulisser par rapport au ressort de contact (5) de telle sorte que la branche de contact flexible (12) du ressort de contact (5) est poussée par le haut de ressort (15) en direction de la branche de contact rigide (13) de telle sorte que la ligne de raccordement (6) est mise en contact en étant coincée entre les deux branches de contact (12, 13).

6. Dispositif de raccordement et de connexion selon la revendication 5, **caractérisé en ce que** la zone d'extrémité (19) de la branche de contact flexible (12) est coudée en direction de la branche de contact rigide (13), l'extrémité (22) de la branche de contact (12) étant de préférence coudée vers l'arrière de sorte que la branche de contact (12) présente une zone de contact arrondie.

7. Dispositif de raccordement et de connexion selon la revendication 6, **caractérisé en ce que** la branche de contact flexible (12), en partant du dos (14) du ressort de contact (5), est tout d'abord coudée en direction de la branche de contact rigide (13) et ensuite de nouveau en s'éloignant de la branche de contact rigide (13) vers sa zone d'extrémité (19), de sorte que le ressort de contact (5) présente une zone (21) disposée entre le dos (14) et les zones d'extrémité (19, 20) des branches de contact (12, 13) dans laquelle les branches de contact (12, 13) présentent un espacement plus faible l'une de l'autre.

8. Dispositif de raccordement et de connexion selon la revendication 4 ou 7, **caractérisé en ce que** les extrémités (24, 25) des branches de ressort (16, 17) du haut de ressort (15) sont coudées l'une vers l'autre et **en ce que** les hauts de ressort (15), avant la mise en place ou l'enfoncement de la partie supérieure de boîtier (4) sur la partie inférieure de boîtier (3), chevauchent avec leurs extrémités (24, 25) les dos (14) des ressorts de contact (5) et se terminent dans la zone (21) dans laquelle les branches de contact (12, 13) du ressort de contact (5) présentent un espacement plus faible l'une de l'autre.

9. Dispositif de raccordement et de connexion selon l'une des revendications 1 à 8, **caractérisé en ce qu'**au moins un porte-contact (26) en matériau isolant est relié avec la partie inférieure de boîtier (3), dans lequel est maintenue l'au moins une pièce métallique (9).

10. Dispositif de raccordement et de connexion selon la revendication 9, **caractérisé en ce que** le porte-contact (26) est relié de manière mobile avec la partie inférieure de boîtier (3) de telle sorte que le porte-contact (26), lors de la mise en place ou de l'enfoncement de la partie supérieure de boîtier (4) sur la partie inférieure de boîtier (3), peut être amené d'une première position dans une deuxième position, les zones d'extrémité (19, 20) des branches de contact (12, 13) du ressort de contact (5), dans la première position du porte-contact (26), étant positionnées au-dessus d'une ligne de raccordement (6) à raccorder même lorsque la partie inférieure de boîtier (3) est posée sur l'appareil électrique, alors que la ligne de raccordement (6), dans la deuxième position du porte-contact (26), est disposée entre les zones d'extrémité (19, 20) des branches de contact (12, 13) du ressort de contact (5).

11. Dispositif de raccordement et de connexion selon la revendication 10, **caractérisé en ce qu'**entre la partie inférieure de boîtier (3) et le porte-contact (26) sont formés deux enclenchements (29, 30, 32) par le biais desquels le porte-contact (26) peut être fixé aussi bien dans sa première position que dans sa deuxième position.

12. Dispositif de raccordement et de connexion selon l'une des revendications 1 à 8, **caractérisé en ce que** la pièce métallique (9) est reliée directement, notamment d'une seule pièce, avec le ressort de contact (5), et par le biais d'un composant supplémentaire, notamment un circuit imprimé (35) ou une grille de connexion, indirectement avec l'élément de raccordement (7).

13. Dispositif de raccordement et de connexion selon la revendication 12, **caractérisé en ce que** la pièce métallique (9) présente à son extrémité libre, non reliée avec le ressort de contact (5), au moins une broche de raccordement à braser (36) par le biais de laquelle la pièce métallique (9) est reliée avec le composant supplémentaire.

14. Dispositif de raccordement et de connexion selon l'une des revendications 1 à 13, **caractérisé en ce qu'**entre la partie inférieure de boîtier (3) et la partie supérieure de boîtier (4) sont formés deux enclenchements (27, 28, 33) par le biais desquels la partie inférieure de boîtier (3) et la partie supérieure de boîtier (4) peuvent être fixées l'une à l'autre aussi bien dans la première position que dans la deuxième position.

15. Dispositif de raccordement et de connexion selon l'une des revendications 1 à 14, **caractérisé en ce que** la partie inférieure de boîtier (3) est réalisée sous la forme d'un cadre de boîtier avec fond ouvert et la partie supérieure de boîtier (4) sous la forme d'un couvercle.

16. Dispositif de raccordement et de connexion selon l'une des revendications 1 à 15, **caractérisé en ce que** deux ressorts de contact (5), deux éléments de raccordement (7), deux pièces métalliques (9) et deux hauts de ressort (15) sont prévus et **en ce que** les deux pièces métalliques (9) sont reliées par une diode de roue libre.
